# EUROPÄISCHE PATENTSCHRIFT

(11) **EP 1 970 726 B1**
(45) Veröffentlichungstag und Bekanntmachung des Hinweises auf die Patenterteilung: **20.01.2010**
(21) Anmeldenummer: 08101126.4
(22) Anmeldetag: 31.01.2008
(51) Int. Cl.: G01S 7/03, H05K 7/20

(54) **Sensorvorrichtung für ein Kraftfahrzeug**
Sensor device for a motor vehicle
Dispositif de capteur pour un véhicule automobile

(30) Priorität: 15.03.2007 DE 102007012456
(43) Veröffentlichungstag der Anmeldung: 17.09.2008
(73) Patentinhaber: ROBERT BOSCH GMBH, 70442 Stuttgart (DE)
(72) Erfinder: Hildebrandt, Juergen, 73235 Weilheim (DE); Schneider, Thomas, 71706 Markgroeningen (DE); Hauk, Joachim, 71272 Renningen-Malmsheim (DE)

(56) Entgegenhaltungen:
- EP-A- 0 957 371
- DE-C1- 19 621 075

## Beschreibung

### Stand der Technik

Die Erfindung betrifft eine Sensorvorrichtung, insbesondere Radarsensorvorrichtung für ein Kraftfahrzeug gemäß dem Oberbegriff von Anspruch 1.

Derartige Sensorvorrichtungen werden als Abstandssensoren in Geschwindigkeitsregelsystemen für Kraftfahrzeuge eingesetzt, mit welchen die Geschwindigkeit des Kraftfahrzeugs auf eine von dem Fahrer gewählte Wunschgeschwindigkeit geregelt werden kann. Mit Hilfe der Abstandssensoren, beispielsweise eines Radarsensors, Lidarsensors oder eines optischen Sensors, kann der Abstand zu einem vorausfahrenden Fahrzeug gemessen werden. Die Geschwindigkeitsregelung wird dann so modifiziert, dass ein vorgegebener, vorzugsweise geschwindigkeitsabhängiger Abstand zu dem als Zielobjekt ausgewählten vorausfahrenden Fahrzeug eingehalten wird. Solche Systeme werden auch als adaptive Geschwindigkeitsregelvorrichtungen / -systeme bzw. ACC(Adaptive Cruise Control)-Systeme bezeichnet. In der Publikation der Robert Bosch GmbH "Adaptive Fahrgeschwindigkeitsregelung ACC, Gelbe Reihe, Ausgabe 2002, Technische Unterrichtung" sind derartige adaptive Geschwindigkeitsregelvorrichtungen beschrieben. Dort ist ebenfalls eine gattungsgemäße Sensorvorrichtung angegeben.

Bisherige Sensoren bzw. deren Steuergeräte besitzen Gehäuse aus Aluminium-Druckguss und weisen Kunststoffteile auf. Die während des Betriebs entstehende Wärme bzw. Wärmestrahlung wird im Wesentlichen über die raue Gussoberfläche des Gehäuses abgegeben. Die Sensoren werden in der Regel im vorderen Bereich des Kraftfahrzeugs, insbesondere im Motorraum angeordnet. Dort befinden sich auch weitere wärmabgebende bzw. wärmeabstrahlende Fahrzeugkomponenten, welche die Gerätetemperatur der Sensoren negativ beeinflussen, d. h. erhöhen können. Wärme wird grundsätzlich über zwei unterschiedliche Wege abgegeben, nämlich zum einen durch Abgabe an das Umgebungsmedium (z. B. Luft) über direkten Kontakt und zum anderen durch Wärmeabstrahlung. Bei der Wärmeabstrahlung besteht die Problematik, dass Oberflächen, die zur Wärmeabstrahlung geeignet sind, ebenfalls leicht Wärmeabstrahlung anderer Quellen absorbieren können.

Die EP 0 957 371 A2 betrifft einen Sensor, insbesondere für den Einsatz in einem Kraftfahrzeug, welcher mindestens ein Antennenelement zum Aussenden einer Strahlung und/oder Empfangen einer von Objekten reflektierten Strahlung aufweist und in einem Gehäuse angeordnet ist. Ein Sensor, welcher schwingfest ausgebildet und trotzdem einfach herzustellen ist, besitzt ein Antennenelement, welches aus einer Gehäusewandung geformt ist. Da das Gehäuse als Metallgehäuse ausgebildet ist, ist eine Abfuhr der Wärme, die während der Funktion der sich auf den Trägerelementen befindenden Bauelemente von diesen erzeugt wird, durch das Gehäuse besonders günstig zu realisieren, wenn das Trägerelement mit der Bauelemente tragenden Seite der plan ausgebildeten Gehäusewandung direkt gegenüber liegt.

### Vorteile der Erfindung

Die erfindungsgemäße Sensorvorrichtung, insbesondere Radarsensorvorrichtung für ein Kraftfahrzeug mit einem Gehäuse, welches, insbesondere auf der Außenseite des Gehäuses, mehrere Oberflächenbereiche aufweist, wobei wenigstens ein erster der mehreren Oberflächenbereiche poliert ist und externe Wärmestrahlung reflektiert und wenigstens ein zweiter der mehreren Oberflächenbereiche rau ist und Wärme durch Wärmestrahlung des Gehäuses abgibt, wobei der wenigstens eine erste Oberflächenbereich und der wenigstens eine zweite Oberflächenbereich auf die Wärmestrahlung in der Umgebung der Sensorvorrichtung im eingebauten Zustand abgestimmt sind, hat den Vorteil, dass unter den im jeweiligen Kraftfahrzeug bzw. dessen Motorraum herrschenden Umgebungsbedingungen eine möglichst geringe Gerätetemperatur für die Sensorvorrichtung erreicht wird. Eine Optimierung wird dadurch erreicht, dass bei der Gestaltung der Oberflächen des Gehäuses der Sensorvorrichtung die Umgebungsbedingungen - unter Einbezug der Gesetzmäßigkeiten der Strahlungsoptik - berücksichtigt werden.

Vorteilhaft ist es, wenn der wenigstens eine erste Oberflächenbereich des Gehäuses weiteren wärmeabstrahlenden Komponenten des Kraftfahrzeugs zugewandt ist. Sonach kann die von anderen Fahrzeugkomponenten abgegebene Wärmeabstrahlung wenigstens teilweise reflektiert werden und trägt nicht zur Erhitzung des Gehäuses der Sensorvorrichtung bei. Der wenigstens eine erste polierte Oberflächenbereich des Gehäuses kann dazu Aluminium aufweisen.

Vorteilhaft ist außerdem, wenn der wenigstens eine zweite Oberflächenbereich des Gehäuses Karosserieaußenteilen des Kraftfahrzeugs oder dessen Außenumgebung zugewandt ist. Dementsprechend kann die im Inneren des Gehäuses der Sensorvorrichtung entstehende Wärme über den zweiten Oberflächenbereich abgegeben werden.

Anspruch 4 betrifft eine adaptive Geschwindigkeitsregelvorrichtung. Ein Kraftfahrzeug ist in Anspruch 5 angegeben.

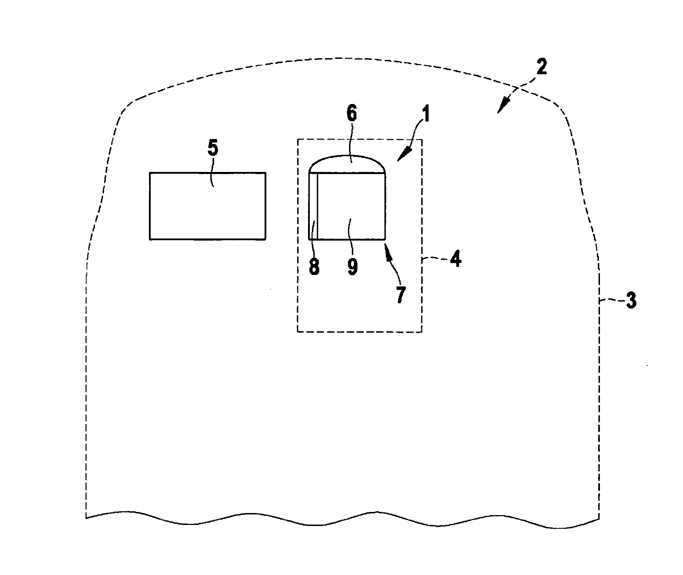

Nachfolgend ist anhand der Zeichnung ein Ausführungsbeispiel der Erfindung prinzipmäßig beschrieben.

### Kurzbeschreibung der Zeichnung

Die einzige Figur der Zeichnung zeigt eine erfindungsgemäße Sensorvorrichtung, welche in einem Motorraum eines Kraftfahrzeugs angeordnet ist.

### Beschreibung von Ausführungsbeispielen

In der Figur ist eine als Radarsensorvorrichtung 1 ausgebildete erfindungsgemäße Sensorvorrichtung dargestellt, welche in einem Motorraum 2 eines Kraftfahrzeugs 3 (stark vereinfacht und gestrichelt angedeutet) angeordnet ist. Die Radarsensorvorrichtung 1 ist Bestandteil einer adaptiven Geschwindigkeitsregelvorrichtung 4 (ebenfalls stark vereinfacht und gestrichelt angedeutet). Derartige adaptive Geschwindigkeitsregelvorrichtungen 4 sind beispielsweise in der Publikation der Robert Bosch GmbH "Adaptive Fahrgeschwindigkeitsregelung ACC, Gelbe Reihe, Ausgabe 2002, Technische Unterrichtung" näher beschrieben, weshalb nachfolgend nicht näher darauf eingegangen wird. Das Kraftfahrzeug 3 weist im Motorraum 2 ebenfalls einen Motorkühler bzw. Kühler 5 auf. Die Radarsensorvorrichtung 1 weist eine Linse 6 und in ihrem Gehäuse 7 weitere - nicht näher dargestellte - Elemente, wie beispielsweise einen Radar-Transceiver oder dergleichen auf. In weiteren nicht dargestellten Ausführungsbeispielen kann die erfindungsgemäße Sensorvorrichtung selbstverständlich auch als Lidarsensor, optischer Sensor oder dergleichen ausgebildet sein.

Die Radarsensorvorrichtung 1 bzw. deren Gehäuse 7 weisen des Weiteren erste und zweite Oberflächenbereiche 8 und 9 auf. Der erste Oberflächenbereich 8 reflektiert eine externe Wärmestrahlung, welche beispielsweise von dem Kühler 5 abgestrahlt wird und der zweite Oberflächenbereich 9 gibt Wärme durch Wärmestrahlung des Gehäuses 7 bzw. der in dem Gehäuse 7 angeordneten weiteren Elemente ab. Der erste Oberflächenbereich 8 und der zweite Oberflächenbereich 9 sind auf die Wärmestrahlung in der Umgebung der Radarsensorvorrichtung 1 im eingebauten Zustand im Motorraum 2 des Kraftfahrzeugs 3 abgestimmt. In weiteren nicht dargestellten Ausführungsbeispielen könnten selbstverständlich zusätzlich noch weitere Oberflächenbereiche 8 und 9 vorgesehen sein.

Der erste Oberflächenbereich 8 des Gehäuses 7 ist weiteren wärmeabstrahlenden Komponenten, insbesondere dem Kühler 5 des Kraftfahrzeugs 3 zugewandt. Sonach kann die von anderen Fahrzeugkomponenten abgegebene Wärmeabstrahlung wenigstens teilweise reflektiert werden und trägt nicht zur Erhitzung des Gehäuses 7 bzw. der Radarsensorvorrichtung 1 bei. Der wenigstens eine erste Oberflächenbereich 8 des Gehäuses 7 ist dazu vorzugsweise poliert ausgebildet und weist Aluminium auf.

Der zweite Oberflächenbereich 9 des Gehäuses 7 ist Karosserieaußenteilen des Kraftfahrzeugs 3 oder dessen Außenumgebung bzw. der Außenluft bzw. der Straße zugewandt. Dementsprechend kann die im Inneren des Gehäuses 7 der Radarsensorvorrichtung 1 entstehende Wärme über den zweiten Oberflächenbereich 9 abgegeben werden. Der zweite Oberflächenbereich 9 des Gehäuses 7 der Radarsensorvorrichtung ist dazu rau ausgebildet. In weiteren Ausführungsbeispielen kann der zweite Oberflächenbereich auch partiell selektiv beschichtet ausgebildet sein.

## Patentansprüche

1. Sensorvorrichtung, insbesondere Radarsensorvorrichtung (1) für ein Kraftfahrzeug (3) mit einem Gehäuse (7), welches mehrere Oberflächenbereiche (8,9) aufweist, **dadurch gekennzeichnet, dass** wenigstens ein ersten (8) der mehreren Oberflächenbereiche poliert ist und externe Wärmestrahlung reflektiert und wenigstens ein zweite (9) der mehreren Oberflächebereiche rau ist und Wärme durch Wärmestrahlung des Gehäuses (7) abgibt, wobei der wenigstens eine erste Oberflächenbereich (8) und der wenigstens eine zweite Oberflächenbereich (9) auf die Wärmestrahlung in der Umgebung der Sensorvorrichtung (1) im eingebauten Zustand abgestimmt sind.

2. Sensorvorrichtung nach Anspruch 1, **dadurch gekennzeichnet, dass** der wenigstens eine erste Oberflächenbereich (8) des Gehäuses (7) weiteren wärmeabstrahlenden Komponenten (5) des Kraftfahrzeugs (3) zugewandt ist.

3. Sensorvorrichtung nach Anspruch 1 oder 2, **dadurch gekennzeichnet, dass** der wenigstens eine zweite Oberflächenbereich (9) des Gehäuses (7) Karosserieaußenteilen des Kraftfahrzeugs (3) oder dessen Außenumgebung zugewandt ist.

4. Adaptive Geschwindigkeitsregelvorrichtung (4) für Kraftfahrzeuge (3) mit wenigstens einer Sensorvorrichtung (1) nach einem der Ansprüche 1, 2 oder 3.

5. Kraftfahrzeug (3) mit wenigstens einer Sensorvorrichtung (1) nach einem der Ansprüche 1, 2 oder 3.

## Claims

1. Sensor device, in particular a radar sensor device (1) for a motor vehicle (3) having a housing (7) which has a plurality of surface regions (8, 9), **characterized in that** at least a first (8) of a plurality of surface regions is polished and reflects external thermal radiation, and at least a second (9) of the plurality of surface regions is rough and outputs heat through thermal radiation of the housing (7), wherein the at least one first surface region (8) and the at least one second surface region (9) are adapted to the thermal radiation in the surroundings of the sensor device (1) in the installed state.

2. Sensor device according to Claim 1, **characterized in that** the at least one first surface region (8) of the housing (7) faces further heat-radiating components (5) of the motor vehicle (3).

3. Sensor device according to Claim 1 or 2, **characterized in that** the at least one second surface region (9) of the housing (7) faces outer parts of the bodywork of the motor vehicle (3) or the external surroundings thereof.

4. Adaptive cruise controller (4) for motor vehicles (3) having at least one sensor device (1) according to one of Claims 1, 2 or 3.

5. Motor vehicle (3) having at least one sensor device (1) according to one of Claims 1, 2 or 3.

## Revendications

1. Dispositif de détection, en particulier dispositif (1) de détection de radar pour un véhicule automobile (3), qui présente un boîtier (7) doté de plusieurs parties de surface (8, 9),
**caractérisé en ce que**
au moins une première (8) des différentes parties de surface est polie et réfléchit un rayonnement thermique externe et au moins une deuxième (9) des différentes parties de surface est rugueuse et délivre de la chaleur par rayonnement thermique du boîtier (7) et
**en ce qu'**au moins une première partie de surface (8) et la ou les deuxièmes parties de surface (9) sont à l'état monté accordées au rayonnement thermique de l'environnement du dispositif de détecteur (1).

2. Dispositif de détecteur selon la revendication 1, **caractérisé en ce que** la ou les premières parties de surface (8) du boîtier (7) sont tournées vers d'autres composants (5) émetteurs de chaleur du véhicule automobile (3).

3. Dispositif de détecteur selon les revendications 1 ou 2, **caractérisé en ce que** la ou les deuxièmes parties de surface (9) du boîtier (7) sont orientées vers des parties extérieures de la carrosserie du véhicule automobile (3) ou vers son environnement extérieur.

4. Dispositif (4) de régulation adaptative de la vitesse d'un véhicule automobile (3) doté d'au moins un dispositif de détection (1) selon l'une des revendications 1, 2 ou 3.

5. Véhicule automobile (3) doté d'au moins un dispositif de détecteur (1) selon l'une des revendications 1, 2 ou 3.
